# EUROPÄISCHE PATENTSCHRIFT

(11) **EP 3 025 375 B1**
(45) Veröffentlichungstag und Bekanntmachung des Hinweises auf die Patenterteilung: **11.09.2019**
(21) Anmeldenummer: 14744304.8
(22) Anmeldetag: 23.07.2014
(51) Int. Cl.: H01L 31/0236, H01L 31/18, H01L 31/068, C03C 23/00, C03C 17/34

(54) **VERFAHREN ZUR HERSTELLUNG EINER SOLARZELLE, INSBESONDERE EINER SILIZIUM-DÜNNSCHICHT-SOLARZELLE**
METHOD FOR PRODUCING A SOLAR CELL, IN PARTICULAR A SILICON THIN-FILM SOLAR CELL
PROCÉDÉ PERMETTANT DE PRODUIRE UNE CELLULE SOLAIRE, EN PARTICULIER UNE CELLULE SOLAIRE À COUCHE MINCE DE SILICIUM

(30) Priorität: 24.07.2013 DE 102013107910
(43) Veröffentlichungstag der Anmeldung: 01.06.2016
(60) Teilanmeldung: 16187697.4
(73) Patentinhaber: Lilas GmbH, 44263 Dortmund (DE)
(72) Erfinder: LISSOTSCHENKO, Vitalij, 58730 Fröndenberg (DE)
(74) Vertreter: Basfeld, Rainer
(86) Internationale Anmeldenummer: PCT/EP2014/065833
(87) Internationale Veröffentlichungsnummer: WO 2015/011197

(56) Entgegenhaltungen:
- US-A- 3 454 386
- US-A1- 2005 164 038
- US-A1- 2012 298 183
- BUNTE E ET AL: "Textured Glass for Silicon Thin Film Solar Cells", THE COMPILED STATE-OF-THE-ART OF PV SOLAR TECHNOLOGY AND DEPLOYMENTPROCEEDINGS OF THE 24TH EUROPEAN PHOTOVOLTAIC SOLAR ENERGY CONFERENCE AND EXHIBITION, 21. September 2009 (2009-09-21), - 25. September 2009 (2009-09-25), Seiten 2789-2792, XP040530267, Hamburg DOI: 10.4229/24thEUPVSEC2009-3BV.4.12 ISBN: 3-936338-25-6
- GUY BEAUCARNE: "Silicon Thin-Film Solar Cells", ADVANCES IN OPTOELECTRONICS, Bd. 2007, 2007, Seiten 1-12, XP055148385, DOI: 10.1155/2007/36970
- BELL J ET AL: "CHANNEL OPTICAL WAVEGUIDES DIRECTLY WRITTEN IN GLASS WITH AN ELECTRON BEAM", ELECTRONICS LETTERS, IEE STEVENAGE, GB, Bd. 27, Nr. 5, 28. Februar 1991 (1991-02-28), Seiten 448-450, XP000219747, ISSN: 0013-5194
- DUDKO Y V ET AL: "Electron-beam modification of silicate glass surfaces", JOURNAL OF NON-CRYSTALLINE SOLIDS, NORTH-HOLLAND PHYSICS PUBLISHING. AMSTERDAM, NL, Bd. 188, Nr. 1-2, Juli 1995 (1995-07), Seiten 87-92, XP004067979, ISSN: 0022-3093, DOI: 10.1016/0022-3093(95)00096-8

## Beschreibung

Die vorliegende Erfindung betrifft ein Verfahren zur Herstellung einer Solarzelle, insbesondere einer Silizium-Dünnschicht-Solarzelle, gemäß dem Oberbegriff des Anspruchs 1.

Silizium-Dünnschicht-Solarzellen finden vielfältige Anwendungen. Häufig weisen diese einen zu geringen Wirkungsgrad auf, weil das Licht nur zu einem geringen Teil in der mindestens einen Siliziumschicht absorbiert wird. Dies hat teilweise seinen Grund darin, dass bei manchen der aus dem Stand der Technik bekannten Solarzellen keine dicken Siliziumschichten eingesetzt werden oder werden können.

Ein Verfahren der eingangs genannten Art ist aus Bunte, E. et al: "Textured glass for silicon thin film solar cells", 24th European Photovoltaic Solar Energy Conference, 21.09. bis 25.09.2009, Hamburg bekannt. Bei dem in dieser Veröffentlichung beschriebenen Verfahren zur Herstellung einer Silizium-Dünnschicht-Solarzelle wird ein mit einer strukturierten ZnO-Schicht versehenes Glassubstrat mit einer Ionenstrahlung bestrahlt bis die ZnO-Schicht entfernt und das Glassubstrat strukturiert ist. Daran anschließend werden eine neue ZnO-Schicht auf das strukturierte Glassubstrat und eine Siliziumschicht auf die ZnO-Schicht aufgebracht.

Beaucarne, G.: "Silicon thin-film solar cells", Advances in OptoElectronics, Bd. 2007, 2007, Seiten 1 bis 12 beschreibt ebenfalls Verfahren zur Herstellung von Silizium-Dünnschicht-Solarzellen. Allen darin vorgestellten Verfahren gemeinsam ist eine auf ein Glassubstrat aufgebrachte TCO-Schicht. Bei einigen der Verfahren wird auf diese TCO-Schicht vermittels eines ECR-CVD-Verfahrens (electron cyclotron resonance chemical vapor deposition) polykristallines Silizium aufgebracht.

Bell, J et al: "Channel optical waveguides directly written in glass with an electron beam", Electronic Letters, IEE Stevenage, GB, Bd. 27, Nr. 5, 28.02.1991, Seiten 448 bis 450 beschreibt die Herstellung eines Wellenleiters in Glas. Dabei wird ein Elektronenstrahl verwendet, um den Brechungsindex des Glases zu verändern.

US 2012/0298183 A1 offenbart, dass die Strukturierung von Metalloberflächen durch die Beaufschlagung mit Laserstrahlen oder Elektronenstrahlen erfolgen kann.

Die US 2005/0164038 A1 beschreibt ein Verfahren zur Herstellung eines magnetischen Aufzeichnungsmediums auf einer strukturierten Glasfläche. Die Strukturierung der Glasfläche kann dabei mittels einer Elektronenstrahlbeaufschlagung erreicht werden.

Die US 3,454,386 beschreibt Verfahren zur Umkristallisation von Oberflächenschichten eines Glases, wobei in einem Verfahrensschritt die Oberfläche des Glases mit einem Elektronenstrahl beaufschlagt wird.

Dudko, Y. V.: "Electron-beam modification of silicate glass surfaces", Journal of Non-Crystalline Solids, Amsterdam, Bd. 188, Nr. 1 bis 2, Juli 1995 beschreibt die Veränderung einer Glasoberfläche durch die Beaufschlagung mit einem Elektronenstrahl.

Das der vorliegenden Erfindung zugrunde liegende Problem ist die Angabe eines Verfahrens der eingangs genannten Art, das die Fertigung von Solarzellen mit einem höheren Wirkungsgrad ermöglicht.

Dies wird erfindungsgemäß durch ein Verfahren der eingangs genannten Art mit den kennzeichnenden Merkmalen des Anspruchs 1 erreicht. Die Unteransprüche betreffen bevorzugte Ausgestaltungen der Erfindung.

Gemäß Anspruch 1 ist vorgesehen, dass vor dem Aufbringen der TCO-Schicht das Glassubstrat mit einer Elektronenstrahlung beaufschlagt wird, so dass eine Licht streuende Schicht des Glassubstrats entsteht, auf die die TCO-Schicht aufgebracht wird, wobei das Glassubstrat vor und/oder während der Beaufschlagung mit der Elektronenstrahlung auf eine Temperatur zwischen 200° C und 700° C aufgeheizt wird. Durch diese Licht streuende Schicht kann das von der Solarzelle zu absorbierende Licht so gestreut werden, dass Anteile dieses Lichts seitlich abgelenkt werden beziehungsweise unter einem Winkel größer 0° zum Einfallslot verlaufen. Dadurch können diese Anteile des Lichts einen längeren Weg durch die mindestens eine Siliziumschicht zurücklegen, so dass sich deren Absorption vergrößert.

Es kann vorgesehen sein, dass das Glassubstrat vor und/oder während der Beaufschlagung mit der Elektronenstrahlung auf eine Temperatur zwischen 300° C und 500° C, beispielsweise auf eine Temperatur von 400° C aufgeheizt wird. Durch die Bestrahlung mit dem Elektronenstrahl bei gleichzeitiger Erwärmung können leichtere Bestandteile des Glases zumindest teilweise dazu gebracht werden, aus der Oberfläche heraus zu diffundieren. Durch dieses Herausdiffundieren von Bestandteilen des Glases entstehen in der Schicht Licht streuende Strukturen.

Es besteht die Möglichkeit, dass die Elektronenstrahlung einen linienförmigen Querschnitt aufweist und senkrecht zur Längserstreckung der Linie über die Oberfläche des Glassubstrats bewegt wird. Auf diese Weise kann die Oberfläche des Glassubstrats einerseits vergleichsweise schnell mit der Elektronenstrahlung beaufschlagt werden. Andererseits ist die lokale Leistungsdichte nicht so hoch wie bei dem Bewegen einer punktförmigen Intensitätsverteilung über die Oberfläche des Glassubstrats.

Es kann vorgesehen sein, dass auf die TCO-Schicht eine erste Siliziumschicht aufgebracht wird, dass die erste Siliziumschicht mit einer Laserstrahlung oder einer Elektronenstrahlung beaufschlagt wird und dass eine zweite Siliziumschicht auf die bestrahlte erste Siliziumschicht aufgebracht wird. Durch den modularen Aufbau der Siliziumschicht ist diese vergleichsweise beständig. Dadurch kann zumindest die zweite Siliziumschicht mit einer größeren Dicke versehen werden, wodurch auch die Absorption des Lichts vergrößert werden kann.

Es kann dabei vorgesehen werden, dass die zweite Siliziumschicht dicker als die erste Siliziumschicht ist. Es besteht die Möglichkeit, dass die erste Siliziumschicht eine Schichtdicke von weniger als 3,0 µm, insbesondere eine Schichtdicke von weniger als 2,0 µm, vorzugsweise eine Schichtdicke von weniger als 1,0 µm, beispielsweise eine Schichtdicke zwischen 0,5 µm und 1,0 µm aufweist. Weiterhin kann dabei vorgesehen werden, dass die zweite Siliziumschicht eine Schichtdicke zwischen 2,0 µm und 20 µm, insbesondere eine Schichtdicke zwischen 3,5 µm und 15 µm, vorzugsweise eine Schichtdicke zwischen 5 µm und 10 µm aufweist. Durch eine derartige Gestaltung kann erreicht werden, dass die Siliziumschichten sicher auf der TCO-Schicht halten und dass trotzdem durch die große Dicke der zweiten Siliziumschicht eine hohe Absorption und damit ein großer Wirkungsgrad der Solarzelle erreicht wird.

Es kann insbesondere vorgesehen sein, dass die Aufbringung der TCO-Schicht und/oder der mindestens einen Siliziumschicht bei Temperaturen unterhalb von 300°C, vorzugsweise bei Temperaturen unterhalb von 200°C, insbesondere bei Temperaturen unterhalb von 100°C, beispielsweise bei Raumtemperatur erfolgt. Durch diese Maßnahme wird einerseits das erfindungsgemäße Verfahren vereinfacht, weil während der Aufbringung der TCO-Schicht und/oder der mindestens einen Siliziumschicht nicht geheizt werden muss. Andererseits wird durch die Beschichtung bei den genannten niedrigen Temperaturen, insbesondere bei Raumtemperatur eine temperaturinduzierte Beeinträchtigung oder Beschädigung der zu fertigenden Solarzelle verhindert.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: einen schematischen Schnitt durch eine erste mit einem erfindungsgemäßen Verfahren hergestellte Solarzelle;
- Fig. 2: einen schematischen Schnitt durch eine zweite mit einem erfindungsgemäßen Verfahren hergestellte Solarzelle;
- Fig. 3: einen schematischen Schnitt durch eine dritte mit einem erfindungsgemäßen Verfahren hergestellte Solarzelle.

In den Figuren sind gleiche oder funktional gleiche Teile oder Schichten mit gleichen Bezugszeichen versehen.

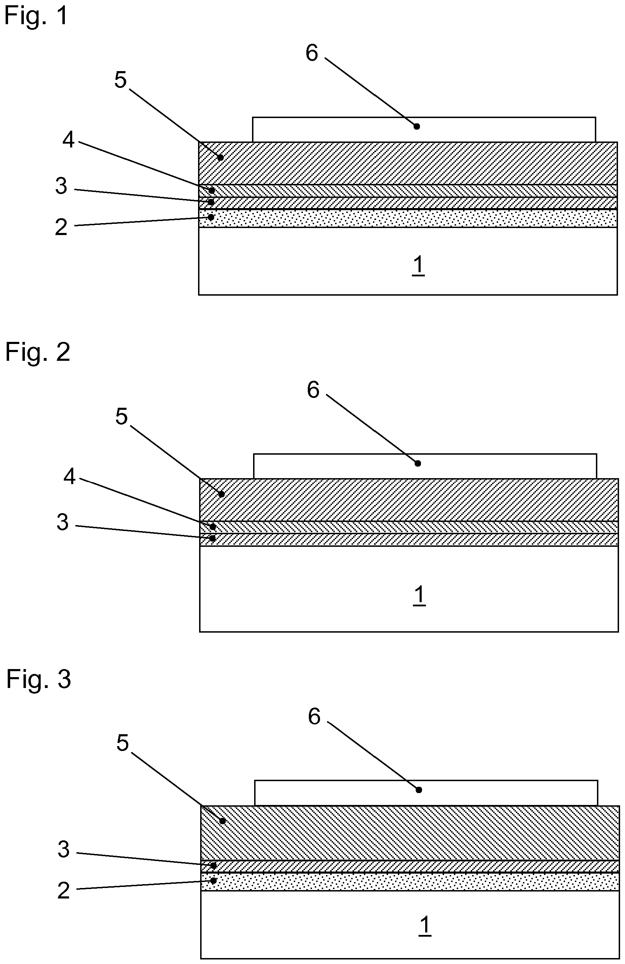

Bei einer ersten Ausführungsvariante der erfindungsgemäßen Verfahren wird ein Glassubstrat 1 auf eine Temperatur zwischen 200° C und 700° C, vorzugsweise auf eine Temperatur zwischen 300° C und 500° C, beispielsweise auf eine Temperatur von 400° C aufgeheizt und auf der in Fig. 1 oben angeordneten Oberfläche mit Elektronenstrahlung beaufschlagt. Insbesondere wird dabei ein Elektronenstrahl mit einem linienförmigen Querschnitt senkrecht zur Linienrichtung über die Oberfläche des Glassubstrats 1 bewegt.

Durch die Bestrahlung mit dem Elektronenstrahl bei gleichzeitiger Erwärmung werden in einer Schicht 2 des Glassubstrats 1 leichtere Bestandteile des Glases teilweise dazu gebracht, aus der Oberfläche heraus zu diffundieren. Es kann sich bei diesen Bestandteilen beispielsweise um Na₂O, K₂O, MgO oder CaO handeln. Durch dieses Herausdiffundieren von Bestandteilen des Glases entstehen in der Schicht 2 Licht streuende Strukturen.

Auf diese Schicht 2 wird in einem weiteren Verfahrensschritt eine TCO-Schicht 3 aufgebracht, die als erste Elektrode der Solarzelle dienen kann. Dies kann mit üblichen Aufbringmethoden, wie beispielsweise dem Aufsputtern geschehen. Insbesondere kann dabei das auszudampfende Material mit einem Elektronenstrahl verdampft werden. Bei der Aufbringung der TCO-Schicht 3 kann sich das Glassubstrat 1 auf Raumtemperatur befinden.

Als TCO-Material kann beispielsweise ZnO verwendet werden. Es besteht aber durchaus auch die Möglichkeit, andere TCO-Materialien, insbesondere andere Zinn- oder Zinkmischoxide, wie beispielsweise ITO, FTO, AZO und ATO, aufzubringen.

Die TCO-Schicht 3 wird in einem weiteren Verfahrensschritt mit Laserstrahlung beaufschlagt, um den Widerstand der TCO-Schicht 3 zu reduzieren. Dabei kann ein Laserstrahl mit einem linienförmigen Querschnitt verwendet werden, der senkrecht zur Linienrichtung über die Oberfläche der TCO-Schicht 3 bewegt wird. Auch bei der Beaufschlagung mit Laserstrahlung kann sich das Glassubstrat 1 auf Raumtemperatur befinden.

Auf die auf Weise bearbeitete TCO-Schicht 3 wird in einem nächsten Verfahrensschritt eine vergleichsweise dünne erste Siliziumschicht 4 aufgebracht. Die erste Siliziumschicht 4 kann eine Schichtdicke von weniger als 3,0 µm, insbesondere eine Schichtdicke von weniger als 2,0 µm, vorzugsweise eine Schichtdicke von weniger als 1,0 µm, beispielsweise eine Schichtdicke zwischen 0,5 µm und 1,0 µm aufweisen.

Die erste Siliziumschicht 4 kann mit üblichen Methoden, wie beispielsweise dem Aufsputtern aufgebracht werden. Insbesondere kann dabei das auszudampfende Silizium mit einem Elektronenstrahl verdampft werden. Bei der Aufbringung der erste Siliziumschicht 4 kann sich das Glassubstrat 1 auf Raumtemperatur befinden.

Die erste Siliziumschicht 4 wird in einem weiteren Verfahrensschritt mit Laserstrahlung oder Elektronenstrahlung beaufschlagt, wobei insbesondere eine Unstrukturierung der ersten Siliziumschicht 4 stattfinden kann, die ihre Haftung auf der TCO-Schicht 3 verbessert. Insbesondere ist die erste Siliziumschicht 4 nach dieser Laserbestrahlung oder Elektronenbestrahlung kratzfest.

Dabei kann ein Laserstrahl oder ein Elektronenstrahl mit einem linienförmigen Querschnitt verwendet werden, der senkrecht zur Linienrichtung über die Oberfläche der ersten Siliziumschicht 4 bewegt wird. Auch bei dieser Beaufschlagung mit Laserstrahlung oder Elektronenstrahlung kann sich das Glassubstrat 1 auf Raumtemperatur befinden.

Auf die erste Siliziumschicht 4 wird in einem nächsten Verfahrensschritt eine vergleichsweise dicke zweite Siliziumschicht 5 aufgebracht. Die zweite Siliziumschicht 5 kann eine Schichtdicke zwischen 2,0 µm und 20 µm, insbesondere eine Schichtdicke zwischen 3,5 µm und 15 µm, vorzugsweise eine Schichtdicke zwischen 5 µm und 10 µm aufweisen.

Die zweite Siliziumschicht 5 kann mit üblichen Methoden, wie beispielsweise dem Aufsputtern aufgebracht werden. Insbesondere kann dabei das auszudampfende Silizium mit einem Elektronenstrahl verdampft werden. Bei der Aufbringung der zweiten Siliziumschicht 5 kann sich das Glassubstrat 1 auf Raumtemperatur befinden.

Die zweite Siliziumschicht 5 wird in einem weiteren Verfahrensschritt mit Laserstrahlung oder Elektronenstrahlung beaufschlagt, wobei insbesondere eine Umstrukturierung der zweiten Siliziumschicht 5 von einem amorphen in einen polykristallinen Zustand stattfinden kann.

Dabei kann ein Laserstrahl oder ein Elektronenstrahl mit einem linienförmigen Querschnitt verwendet werden, der senkrecht zur Linienrichtung über die Oberfläche der zweiten Siliziumschicht 5 bewegt wird. Auch bei dieser Beaufschlagung mit Laserstrahlung oder Elektronenstrahlung kann sich das Glassubstrat 1 auf Raumtemperatur befinden.

In einem weiteren Verfahrensschritt wird auf die Außenseite der zweiten Siliziumschicht 5 eine in Fig. 1 nur schematisch angedeutete zweite metallische Elektrode 6 aufgebracht. Diese kann sich vollflächig über die zweite Siliziumschicht 5 erstrecken oder wie angedeutet auch nur einzelne Bereiche der zweite Siliziumschicht 5 abdecken.

Es besteht durchaus die Möglichkeit, bei einem erfindungsgemäßen Verfahren auf die Vorbehandlung des Glassubstrats 1 mit Elektronenstrahlung zu verzichten. In Fig. 2 ist eine Ausführungsform einer Solarzelle angedeutet, bei der auf die Erstellung der Streuschicht 2 verzichtet wurde.

In diesem Fall kann die TCO-Schicht 3 direkt auf das nicht mit einem Elektronenstrahl vorbehandelte Glassubstrat 1 aufgebracht werden. Alternativ dazu kann auf das Glassubstrat 1 vor Aufbringung der TCO-Schicht 3 eine Pufferschicht aufgebracht werden. Diese Pufferschicht kann vorzugsweise aus Silizium-Dioxid, -Nitrit, oder -Carbid bestehen und beispielsweise zwischen 10 nm und 200 nm, insbesondere zwischen 20 nm und 100 nm dick sein.

Es besteht weiterhin die Möglichkeit, auch auf ein erfindungsgemäß mit Elektronenstrahlung vorbehandeltes Glassubstrat 1 eine Pufferschicht aufzubringen. Auch diese Pufferschicht kann vorzugsweise aus Silizium-Dioxid, -Nitrit, oder -Carbid bestehen und beispielsweise zwischen 10 nm und 200 nm, insbesondere zwischen 20 nm und 100 nm dick sein.

Es besteht weiterhin die Möglichkeit, bei einem erfindungsgemäßen Verfahren die Siliziumschicht nicht modular aus zwei Teilschichten zusammenzusetzen, sondern lediglich eine Siliziumschicht vorzusehen. In Fig. 3 ist eine Ausführungsform einer Solarzelle angedeutet, bei der zwar eine Streuschicht 2 erstellt wurde, wobei aber auf die dünne erste Siliziumschicht 4 verzichtet wurde. In diesem Fall wird erfindungsgemäß die vergleichsweise dicke Siliziumschicht 5 direkt auf die TCO-Schicht 3 aufgebracht.

## Patentansprüche

1. Verfahren zur Herstellung einer Solarzelle, insbesondere einer Silizium-Dünnschicht-Solarzelle, umfassend folgende Verfahrensschritte:
- Aufbringen einer TCO-Schicht (3) auf ein Glassubstrat (1);
- Aufbringen mindestens einer Siliziumschicht (4, 5) auf die TCO-Schicht (3);
**dadurch gekennzeichnet, dass** vor dem Aufbringen der TCO-Schicht (3) das Glassubstrat (1) mit einer Elektronenstrahlung beaufschlagt wird, so dass eine Licht streuende Schicht (2) des Glassubstrats (1) entsteht, auf die die TCO-Schicht (3) aufgebracht wird, wobei das Glassubstrat (1) vor und/oder während der Beaufschlagung mit der Elektronenstrahlung auf eine Temperatur zwischen 200° C und 700° C aufgeheizt wird.

2. Verfahren zur Herstellung einer Solarzelle nach Anspruch 1, **dadurch gekennzeichnet, dass** das Glassubstrat (1) vor und/oder während der Beaufschlagung mit der Elektronenstrahlung auf eine Temperatur zwischen 300° C und 500° C, beispielsweise auf eine Temperatur von 400° C aufgeheizt wird.

3. Verfahren zur Herstellung einer Solarzelle nach einem der Ansprüche 1 oder 2, **dadurch gekennzeichnet, dass** die Elektronenstrahlung einen linienförmigen Querschnitt aufweist und senkrecht zur Längserstreckung der Linie über die Oberfläche des Glassubstrats (1) bewegt wird.

4. Verfahren zur Herstellung einer Solarzelle nach einem der Ansprüche 1 bis 3, **dadurch gekennzeichnet, dass** die TCO-Schicht (3) mit einer Laserstrahlung beaufschlagt wird.

5. Verfahren zur Herstellung einer Solarzelle nach einem der Ansprüche 1 bis 4, **dadurch gekennzeichnet, dass** auf die TCO-Schicht (3) eine erste Siliziumschicht (4) aufgebracht wird, dass die erste Siliziumschicht (4) mit einer Laserstrahlung oder einer Elektronenstrahlung beaufschlagt wird und dass eine zweite Siliziumschicht (5) auf die bestrahlte erste Siliziumschicht (4) aufgebracht wird.

6. Verfahren zur Herstellung einer Solarzelle nach Anspruch 5, **dadurch gekennzeichnet, dass** die zweite Siliziumschicht (5) dicker als die erste Siliziumschicht (4) ist.

7. Verfahren zur Herstellung einer Solarzelle nach einem der Ansprüche 5 oder 6, **dadurch gekennzeichnet, dass** die erste Siliziumschicht (4) eine Schichtdicke von weniger als 3,0 µm, insbesondere eine Schichtdicke von weniger als 2,0 µm, vorzugsweise eine Schichtdicke von weniger als 1,0 µm, beispielsweise eine Schichtdicke zwischen 0,5 µm und 1,0 µm aufweist.

8. Verfahren zur Herstellung einer Solarzelle nach einem der Ansprüche 5 bis 7, **dadurch gekennzeichnet, dass** die zweite Siliziumschicht (5) eine Schichtdicke zwischen 2,0 µm und 20 µm, insbesondere eine Schichtdicke zwischen 3,5 µm und 15 µm, vorzugsweise eine Schichtdicke zwischen 5 µm und 10 µm aufweist.

9. Verfahren zur Herstellung einer Solarzelle nach einem der Ansprüche 5 bis 8, **dadurch gekennzeichnet, dass** die zweite Siliziumschicht (5) mit einer Laserstrahlung oder einer Elektronenstrahlung beaufschlagt wird.

10. Verfahren zur Herstellung einer Solarzelle nach einem der Ansprüche 1 bis 9, **dadurch gekennzeichnet, dass** die Laserstrahlung oder die Elektronenstrahlung einen linienförmigen Querschnitt aufweist und senkrecht zur Längserstreckung der Linie über die Oberfläche des Glassubstrats (1) bewegt wird.

11. Verfahren zur Herstellung einer Solarzelle nach einem der Ansprüche 1 bis 10, **dadurch gekennzeichnet, dass** die TCO-Schicht (3) vermittels eines Elektronenstrahls aufgedampft wird.

12. Verfahren zur Herstellung einer Solarzelle nach einem der Ansprüche 1 bis 11, **dadurch gekennzeichnet, dass** die mindestens eine Siliziumschicht (4, 5) vermittels eines Elektronenstrahls aufgedampft wird.

13. Verfahren zur Herstellung einer Solarzelle nach einem der Ansprüche 1 bis 12, **dadurch gekennzeichnet, dass** die Aufbringung der TCO-Schicht (3) bei Temperaturen unterhalb von 300°C, vorzugsweise bei Temperaturen unterhalb von 200°C, insbesondere bei Temperaturen unterhalb von 100°C, beispielsweise bei Raumtemperatur erfolgt.

14. Verfahren zur Herstellung einer Solarzelle nach einem der Ansprüche 1 bis 12, **dadurch gekennzeichnet, dass** die Aufbringung der TCO-Schicht (3) und/oder der mindestens einen Siliziumschicht (4, 5) bei Temperaturen unterhalb von 300°C, vorzugsweise bei Temperaturen unterhalb von 200°C, insbesondere bei Temperaturen unterhalb von 100°C, beispielsweise bei Raumtemperatur erfolgt.

15. Verfahren zur Herstellung einer Solarzelle nach einem der Ansprüche 1 bis 14, **dadurch gekennzeichnet, dass** auf die mindestens eine Siliziumschicht (4, 5) beziehungsweise die zweite Siliziumschicht (5) eine Elektrode (6) aus einem elektrisch leitfähigen Material aufgebracht wird.

## Claims

1. Method for producing a solar cell, in particular a silicon thin-film solar cell, comprising the following method steps:
- depositing a TCO layer (3) on a glass substrate (1);
- depositing at least one silicon layer (4, 5) on the TCO layer (3);
**characterised in that,** before the TCO layer (3) is deposited, the glass substrate (1) is exposed to electron radiation, forming a light-scattering layer (2) of the glass substrate (1), on which layer the TCO layer (3) is deposited, the glass substrate (1) being heated to a temperature between 200°C and 700°C before and/or during exposure to the electron radiation.

2. Method for producing a solar cell according to claim 1, **characterised in that** the glass substrate (1) is heated to a temperature between 300°C and 500°C, for example to a temperature of 400°C, before and/or during exposure to the electron radiation.

3. Method for producing a solar cell according to any of claims 1 or 2, **characterised in that** the electron radiation has a line-shaped cross-section and is moved across the surface of the glass substrate (1) perpendicular to the longitudinal extent of the line.

4. Method for producing a solar cell according to any of claims 1 to 3, **characterised in that** the TCO layer (3) is exposed to laser radiation.

5. Method for producing a solar cell according to any of claims 1 to 4, **characterised in that** a first silicon layer (4) is deposited on the TCO layer (3), **in that** the first silicon layer (4) is exposed to laser radiation or electron radiation, and **in that** a second silicon layer (5) is deposited on the irradiated first silicon layer (4).

6. Method for producing a solar cell according to claim 5, **characterised in that** the second silicon layer (5) is thicker than the first silicon layer (4).

7. Method for producing a solar cell according to any of claims 5 or 6, **characterised in that** the first silicon layer (4) has a layer thickness of less than 3.0 µm, in particular a layer thickness of less than 2.0 µm, preferably a layer thickness of less than 1.0 µm, for example a layer thickness between 0.5 µm and 1.0 µm.

8. Method for producing a solar cell according to any of claims 5 to 7, **characterised in that** the second silicon layer (5) has a layer thickness between 2.0 µm and 20 µm, in particular a layer thickness between 3.5 µm and 15 µm, preferably a layer thickness between 5 µm and 10 µm.

9. Method for producing a solar cell according to any of claims 5 to 8, **characterised in that** the second silicon layer (5) is exposed to laser radiation or electron radiation.

10. Method for producing a solar cell according to any of claims 1 to 9, **characterised in that** the laser radiation or the electron radiation has a line-shaped cross-section and is moved across the surface of the glass substrate (1) perpendicular to the longitudinal extent of the line.

11. Method for producing a solar cell according to any of claims 1 to 10, **characterised in that** the TCO layer (3) is vapour-deposited by means of an electron beam.

12. Method for producing a solar cell according to any of claims 1 to 11, **characterised in that** the at least one silicon layer (4, 5) is vapour-deposited by means of an electron beam.

13. Method for producing a solar cell according to any of claims 1 to 12, **characterised in that** the TCO layer (3) is deposited at temperatures below 300°C, preferably at temperatures below 200°C, in particular at temperatures below 100°C, for example at room temperature.

14. Method for producing a solar cell according to any of claims 1 to 12, **characterised in that** the TCO layer (3) and/or the at least one silicon layer (4, 5) is deposited at temperatures below 300°C, preferably at temperatures below 200°C, in particular at temperatures below 100°C, for example at room temperature.

15. Method for producing a solar cell according to any of claims 1 to 14, **characterised in that** an electrode (6) made of an electrically conductive material is deposited on the at least one silicon layer (4, 5) or on the second silicon layer (5).

## Revendications

1. Procédé de fabrication d'une cellule solaire, en particulier d'une cellule solaire à couches minces en silicium, comprenant les étapes suivantes :
- application d'une couche TCO (3) sur un substrat en verre (1) ;
- application d'au moins une couche de silicium (4, 5) sur la couche TCO (3) ;
**caractérisé en ce que,** avant l'application de la couche TCO (3), le substrat en verre (1) est exposé à un faisceau électronique de manière à créer une couche (2), dispersant la lumière, du substrat en verre (1), couche sur laquelle est appliquée la couche TCO (3), dans lequel, avant et/ou pendant l'exposition au faisceau électronique, le substrat en verre (1) est chauffé à une température comprise entre 200 °C et 700 °C.

2. Procédé de fabrication d'une cellule solaire selon la revendication 1, **caractérisé en ce que,** avant et/ou pendant l'exposition au faisceau électronique, le substrat en verre (1) est chauffé à une température comprise entre 300 °C et 500 °C, par exemple à une température de 400 °C.

3. Procédé de fabrication d'une cellule solaire selon l'une quelconque des revendications 1 ou 2, **caractérisé en ce que** le faisceau électronique a une section transversale linéaire et est déplacé perpendiculairement à l'extension longitudinale de la ligne au-dessus de la surface du substrat en verre (1).

4. Procédé de fabrication d'une cellule solaire selon l'une quelconque des revendications 1 à 3, **caractérisé en ce que** la couche TCO (3) est exposée à un faisceau laser.

5. Procédé de fabrication d'une cellule solaire selon l'une quelconque des revendications 1 à 4, **caractérisé en ce qu'**une première couche de silicium (4) est appliquée sur la couche TCO (3), **en ce que** la première couche de silicium (4) est exposée à un faisceau laser ou à un faisceau électronique et **en ce qu'**une deuxième couche de silicium (5) est appliquée sur la première couche de silicium (4) exposée au faisceau.

6. Procédé de fabrication d'une cellule solaire selon la revendication 5, **caractérisé en ce que** la deuxième couche de silicium (5) est plus épaisse que la première couche de silicium (4).

7. Procédé de fabrication d'une cellule solaire selon l'une quelconque des revendications 5 ou 6, **caractérisé en ce que** la première couche de silicium (4) a une épaisseur de couche de moins de 3,0 µm, en particulier une épaisseur de couche de moins de 2,0 µm, de préférence une épaisseur de couche de moins de 1,0 µm, par exemple une épaisseur de couche comprise entre 0,5 µm et 1,0 µm.

8. Procédé de fabrication d'une cellule solaire selon l'une quelconque des revendications 5 à 7, **caractérisé en ce que** la deuxième couche de silicium (5) a une épaisseur de couche comprise entre 2,0 µm et 20 µm, en particulier une épaisseur de couche comprise entre 3,5 µm et 15 µm, de préférence une épaisseur de couche comprise entre 5 µm et 10 µm.

9. Procédé de fabrication d'une cellule solaire selon l'une quelconque des revendications 5 à 8, **caractérisé en ce que** la deuxième couche de silicium (5) est exposée à un faisceau laser ou à un faisceau électronique.

10. Procédé de fabrication d'une cellule solaire selon l'une quelconque des revendications 1 à 9, **caractérisé en ce que** le faisceau laser ou le faisceau électronique a une section transversale linéaire et est déplacé perpendiculairement à l'extension longitudinale de la ligne au-dessus de la surface du substrat en verre (1).

11. Procédé de fabrication d'une cellule solaire selon l'une quelconque des revendications 1 à 10, **caractérisé en ce que** la couche TCO (3) est déposée en phase gazeuse au moyen d'un faisceau électronique.

12. Procédé de fabrication d'une cellule solaire selon l'une quelconque des revendications 1 à 11, **caractérisé en ce que** l'au moins une couche de silicium (4, 5) est déposée en phase gazeuse au moyen d'un faisceau électronique.

13. Procédé de fabrication d'une cellule solaire selon l'une quelconque des revendications 1 à 12, **caractérisé en ce que** l'application de la couche TCO (3) s'effectue à des températures inférieures à 300 °C, de préférence à des températures inférieures à 200 °C, en particulier à des températures inférieures à 100 °C, par exemple à température ambiante.

14. Procédé de fabrication d'une cellule solaire selon l'une quelconque des revendications 1 à 12, **caractérisé en ce que** l'application de la couche TCO (3) et/ou de l'au moins une couche de silicium (4, 5) s'effectue à des températures inférieures à 300 °C, de préférence à des températures inférieures à 200 °C, en particulier à des températures inférieures à 100 °C, par exemple à température ambiante.

15. Procédé de fabrication d'une cellule solaire selon l'une quelconque des revendications 1 à 14, **caractérisé en ce qu'**une électrode (6) en un matériau électriquement conducteur est appliquée sur l'au moins une couche de silicium (4, 5) ou sur la deuxième couche de silicium (5).
